# EUROPEAN PATENT APPLICATION

(11) **EP 2 180 509 A1**
(43) Date of publication of application: **28.04.2010**
(21) Application number: 09171987.2
(22) Date of filing: 01.10.2009
(51) Int. Cl.: H01L 27/146, H01L 31/0232

(54) **Light sensor**

(30) Priority: 24.10.2008 JP 2008274965
(71) Applicant: Omron Co., Ltd., Kyoto-shi, Kyoto 600-8530 (JP)
(72) Inventor: Shimizu, Masao, Kyoto-shi Kyoto 600-8530 (JP); Terasaka, Mariko, Kyoto-shi Kyoto 600-8530 (JP); Nakagawa, Shinya, Kyoto-shi Kyoto 600-8530 (JP); Ukai, Shigekazu, Kyoto-shi Kyoto 600-8530 (JP)
(74) Representative: Wilhelms · Kilian & Partner Patentanwälte

(57) **Abstract**

This invention provides a light sensor including an electromagnetic shield conductive film (18), the electromagnetic shield conductive film (18) being removed at a region facing a light detection region, where the electromagnetic noise is prevented from entering even at the region facing the light detection region. A photodiode (13) and an IC circuit (15) are formed on a surface layer of a silicon substrate (12). A light shielding metal (18) is formed on the upper surface of the silicon substrate (12) by way of an insulating layer (16), and the IC circuit (15) is covered by the light shielding metal (18). In a region facing the photodiode (13), a light receiving window (19) is opened in the light shielding metal (18), which light shielding window (19) is covered with a conductive optical filter (32).

## Description

### BACKGROUND OF THE INVENTION

### 1. TECHNICAL FIELD

The present invention relates to light sensors, and more specifically, to a light sensor having a function of shielding electromagnetic noise.

### 2. RELATED ART

A light sensor in which a photodiode (PD), an output amplification IC circuit, and the like are incorporated in a silicon substrate has been proposed.
In such a light sensor, a photodiode capable of detecting light having a wavelength band of visible light to near-infrared light is used, and an optical filter is arranged at the upper part of the photodiode so that only the light of a specific wavelength band can be detected with the photodiode.

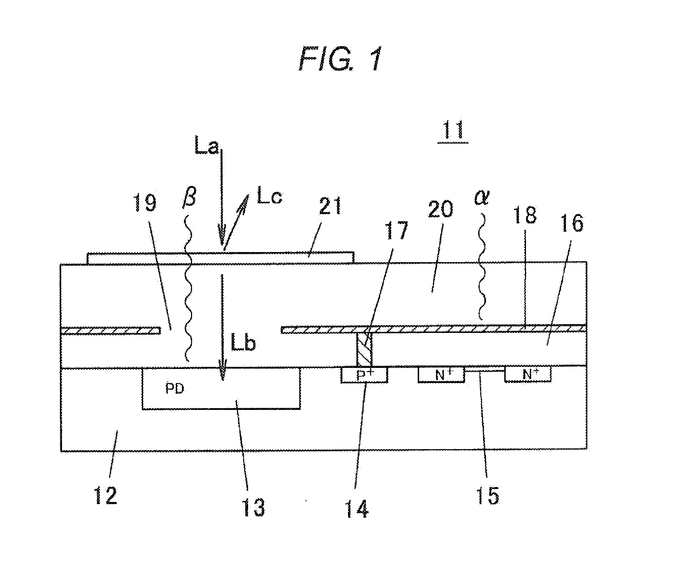

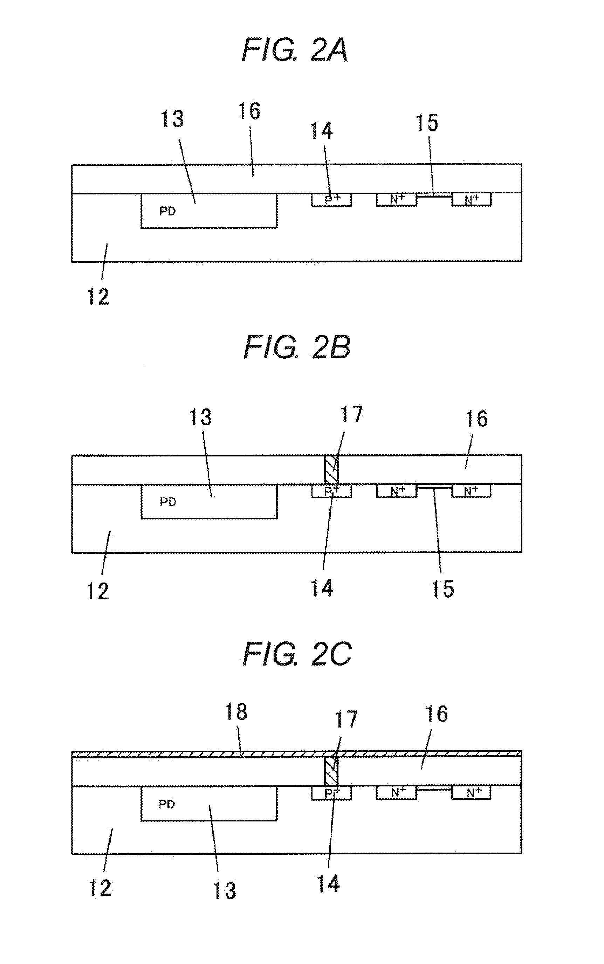

Fig. 1 is a cross-sectional view schematically showing a conventional structure of such a light sensor. Figs. 2A to 2C, Figs. 3A, 3B, and Figs. 4A, 4B are cross-sectional views describing manufacturing steps of the light sensor. Hereinafter, the manufacturing steps of the light sensor 11 will be sequentially described, and at the same time, the structure of the light sensor 11 will be described.

First, a photodiode 13, a ground contact region 14 (P⁺ diffusion layer), an IC circuit 15, and the like are fabricated on a surface layer of a P-type silicon substrate 12 using a semiconductor manufacturing technique. As shown in Fig. 2A, the upper surface of the silicon substrate 12 is covered with an insulating layer 16 made of SiO₂. As shown in Fig. 2B, a through-hole is opened in the insulating layer 16 at a position facing the upper surface of the contact region 14 and a conductive material such as metal or polysilicon is filled in the through-hole to form a conductive post 17, which conductive post 17 is then subjected to thermal treatment to be Ohmic contacted to the contact region 14. As shown in Fig. 2C, a light shielding metal 18 made of a light shielding material such as AlSi is formed on the upper surface of the insulating layer 16, where the upper side of the IC circuit 15 is shielded by the light shielding metal 18 and the light shielding metal 18 is conducted with the contact region 14 through the conductive post 17.

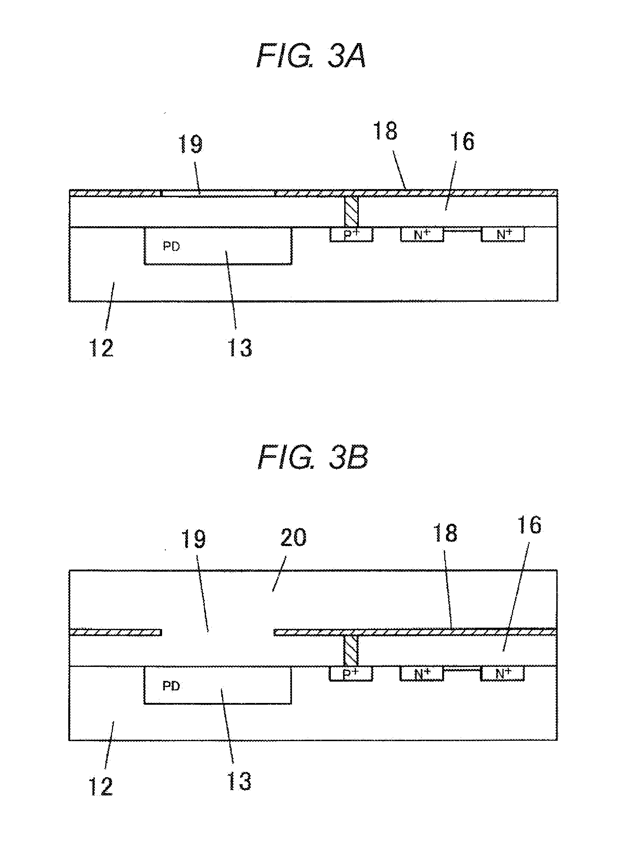

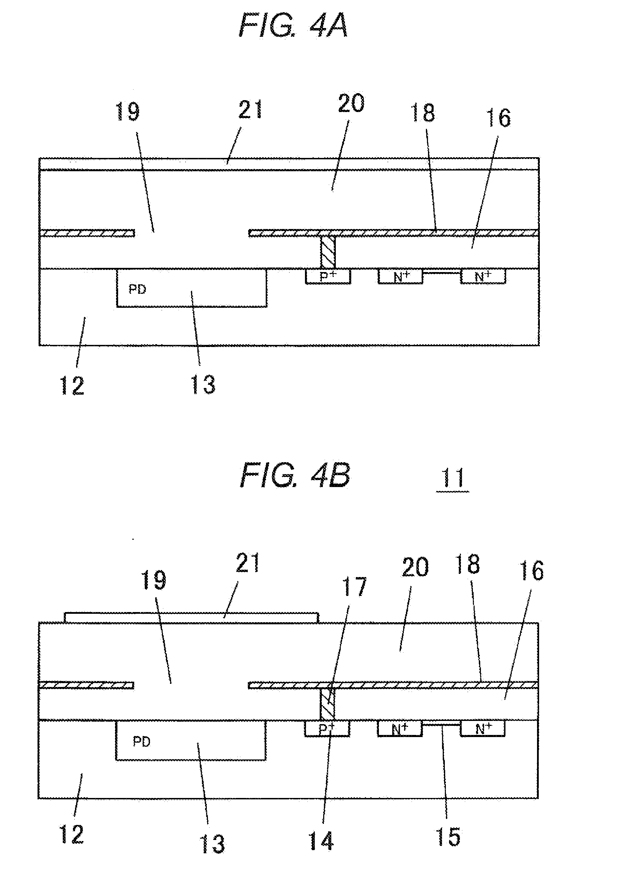

Furthermore, as shown in Fig. 3A, a light receiving window 19 is opened in the light shielding metal 18 at above the photodiode 13 through the photolithography technique. As shown in Fig. 3B, an insulating layer 20 made of SiO₂ is formed at the upper surface of the light shielding metal 18. As shown in Fig. 4A, an optical filter 21 is formed over the entire upper surface of the insulating layer 20 and, as shown in Fig. 4B, with the optical filter 21 at the position facing the upper side of the photodiode 13 remaining, the optical filter 21 of other regions is removed through etching etc., to thereby fabricate the target light sensor 11.

Since the upper side of the IC circuit 15 is covered with the light shielding metal 18 for electromagnetic shield electrically grounded by connecting the contact region 14 to an earth line in such a light sensor 11, the electromagnetic noise α from the outside can be shielded with the light shielding metal 18, as shown in Fig. 1, and malfunction of the IC circuit 15 by the electromagnetic noise α can be prevented. The configuration of covering the upper side of the IC circuit with the light shielding metal is disclosed in Japanese Unexamined Patent Publication No. 11-40790.

Since the light receiving window 19 is opened in the light shielding metal 18 facing the photodiode 13, the incident light from the outside passes through the light receiving window 19 and enters the photodiode 13, and is detected by the photodiode 13. The photodiode 13 itself has sensitivity to light having a wavelength band of visible light to near-infrared light, but the optical filter 21 transmits only the light Lb (e.g., infrared light) having a specific wavelength of the incident light La and reflects light Lc of other wavelength bands, and thus only the light of the specific wavelength band Lb can be detected by the photodiode 13. The configuration of limiting the wavelength of the light entering a light detection region using the optical filter is disclosed in Japanese Unexamined Patent Publication No. 7-170366.

### SUMMARY

However, since the light receiving window 19 is opened in the light shielding metal 18 at the position facing the photodiode 13 in the light sensor 11 having the structure shown in Fig. 1, the electromagnetic noise β may pass through the light receiving window 19, and enter the inner side of the light shielding metal 18. Thus, in places where there are great amount of electromagnetic noise such as inside a factory, malfunction may occur at the photodiode 13 and the contact region 14 due to the electromagnetic noise β that passed through the light receiving window 19. Applications are limited as use is not suitable in places where there are great amount of electromagnetic noise such as inside the factory.

The present invention has been devised to solve the problems described above, and an object thereof is to provide a light sensor including an electromagnetic shield conductive film, the electromagnetic shield conductive film being removed at a region facing a light detection region, where the electromagnetic noise is prevented from entering even at the region facing the light detection region,

In accordance with one aspect of the present invention, in order to achieve the above object, there is provided a light sensor, wherein an element forming region excluding a light detection region is covered with a conductive film having a light shielding property, the light detection region being covered with a conductive film having a light transmissive property.

According to the light sensor of the present invention, since the element forming region such as the IC circuit excluding the light detection region is covered with a conductive film having a light shielding property, light and electromagnetic noise do not reach the IC circuit and the like, and malfunction of the IC circuit and the like due to the light and the electromagnetic noise from the outside can be prevented.

Furthermore, since the light detection region such as the photodiode and the phototransistor is covered with the conductive film having a light transmissive property, the light entering from the outside is transmitted through the conductive film having the light transmissive property and detected in the light detection region, but the electromagnetic noise is shielded by the conductive film having the light transmissive property so that the electromagnetic noise can be more reliably shielded, and malfunction of the light detection region, the IC circuit, and the like can be prevented.
Therefore, according to the light sensor of the present invention, use can be made in places where there are great amount of electromagnetic noise such as inside the factory.

In accordance with one aspect of the light sensor according to the present invention, the conductive film having the light transmissive property has optical filter characteristics. According to such aspect, only the light of a specific wavelength (band) can be selectively detected in the light detection region.

In accordance with another aspect of the light sensor of the present invention, the conductive film having the light transmissive property electrically contacts the conductive film having the light shielding property. According to such aspect, the structure of the light sensor can be simplified since if one of the conductive film having the light transmissive property or the conductive film having the light shielding property is grounded, the other will also be grounded.

The means for solving the problems in the present invention have characteristics appropriately combining the components described above, and the present invention is intended to enable numerous various by combining the components.

### BRIEF DESCRIPTION OF THE DRAWINGS

Fig. 1 is a schematic cross-sectional view showing a structure of a light sensor of a conventional example;
Figs. 2A, 2B, and 2C are cross-sectional views showing manufacturing steps of the light sensor of the conventional example;
Figs. 3A and 3B are cross-sectional views showing manufacturing steps following Fig. 2C;
Figs. 4A and 4B are cross-sectional views showing manufacturing steps following Fig. 3B;
Fig. 5 is a schematic cross-sectional view showing a structure of a light sensor according to a first embodiment of the present invention;
Figs. 6A and 6B are cross-sectional views showing manufacturing steps of the light sensor of the first embodiment;
Figs. 7A and 7B are cross-sectional views showing manufacturing steps following Fig. 6B;
Fig. 8 is a schematic cross-sectional view showing one example of a conductive optical filter; and
Fig. 9 is a schematic cross-sectional view showing a structure of a light sensor according to a second embodiment of the present invention.

### DETAILED DESCRIPTION

Hereinafter, preferred embodiments of the present invention will be described with reference to the accompanying drawings.

### (First Embodiment)

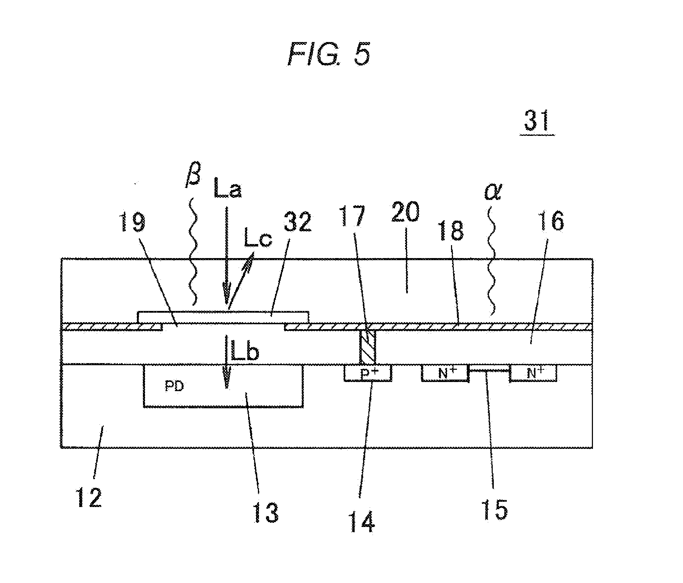

Fig. 5 is a cross-sectional view schematically showing a structure of a light sensor 31 (light sensor chip) according to a first embodiment of the present invention. In the light sensor 31, a photodiode 13 (light detection region), a ground contact region 14 (P⁺ diffusion layer), an IC circuit 15 including a MOS transistor, and the like are fabricated on a surface layer of a P-type silicon substrate 12. The upper surface of the silicon substrate 12 is covered with an insulating layer 16 made of SiO₂, a through-hole is opened in the insulating layer 16 at a position facing the upper surface of the contact region 14 and a conductive material such as metal or polysilicon is filled in the through-hole to form a conductive post 17, which conductive post 17 is then Ohmic contacted to the contact region 14. A light shielding metal 18 made of a light shielding material such as AlSi is formed on the upper surface of the insulating layer 16, where the upper side of the IC circuit 15 is covered by the light shielding metal 18. A light receiving window 19 is opened in the light shielding metal 18 at above the photodiode 13. The light receiving window 19 is covered with an optical filter 21 at a position facing the upper side of the photodiode 13, and an insulating layer 20 made of SiO₂ is formed at the upper surface of the light shielding metal 18.

In the present embodiment, the photodiode 13 is fabricated for the light detection region, but may be a phototransistor. Since the photodiode 13 has sensitivity to light having a wide wavelength band of visible light to near-infrared light, a conductive optical filter 32 is arranged so that only the light of specific wavelength, that is, the light having a transmissive wavelength (band) of the conductive optical filter 32 is detected by the light sensor 31. The specific wavelength is a light emitting wavelength of an LED used as a pair with the light sensor 31. where the wavelength is λ = 870 nm in the case of an infrared LED.

The contact region 14 is connected to the earth line when the light sensor 31 is mounted on a circuit board and the like, whereby the light shielding metal 18 is also grounded by way of the conductive post 17 and the contact region 14. The light shielding metal 18 is opaque and does not transmit light. Thus, the light shielding metal 18 covering the IC circuit 15 acts as an electromagnetic shield film or a light shielding film, so that the electromagnetic noise a and the incident light from the outside can be shielded by the light shielding metal 18 as shown in Fig. 5, and malfunction of the IC circuit 15 by the electromagnetic noise α and the incident light can be prevented.

The conductive optical filter 32 has both a function as a band-pass filter for transmitting light of a specific wavelength (e.g., infrared light wavelength) and a function as a conductive film. The conductive optical filter 32 is formed so as to contact and electrically conduct with the light shielding metal 18, and is maintained at the same potential (i.e., ground potential) as the light shielding metal 18.

Since the photodiode 13 is covered with such a conductive optical filter 32, the light sensor 31 can detect only the light of a specific wavelength, that is, the light of the transmissive wavelength band of the conductive optical filter 32. In other words, only the light Lb (e.g., infrared light) having a specific wavelength band of the incident light La transmits through the conductive optical filter 32, and the light Lc of other wavelength bands is reflected by the conductive optical filter 32, and thus only the light of the specific wavelength band Lb is detected by the photodiode 13.

Furthermore, the electromagnetic noise β entered to the light receiving window 19 from the outside is shielded by the conductive optical filter 32. Thus, the electromagnetic noises α, β can be shielded over the entire surface by the light shielding metal 18 and the conductive optical filter 32, and the malfunction of the photodiode 13, the IC circuit 15; and the like can be more reliably prevented. Thus, according to such a light sensor 31, use can be made in places where there are great amount of electromagnetic noise such as inside the factory.

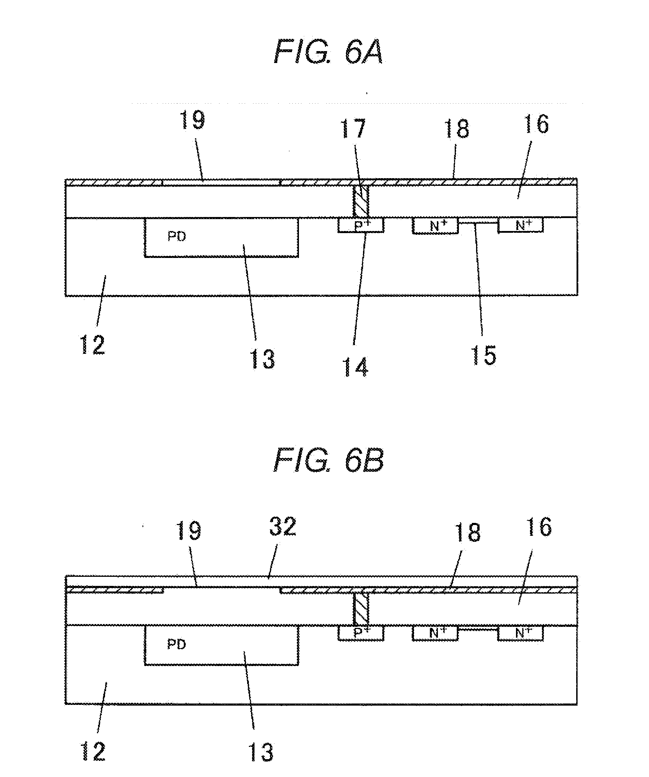

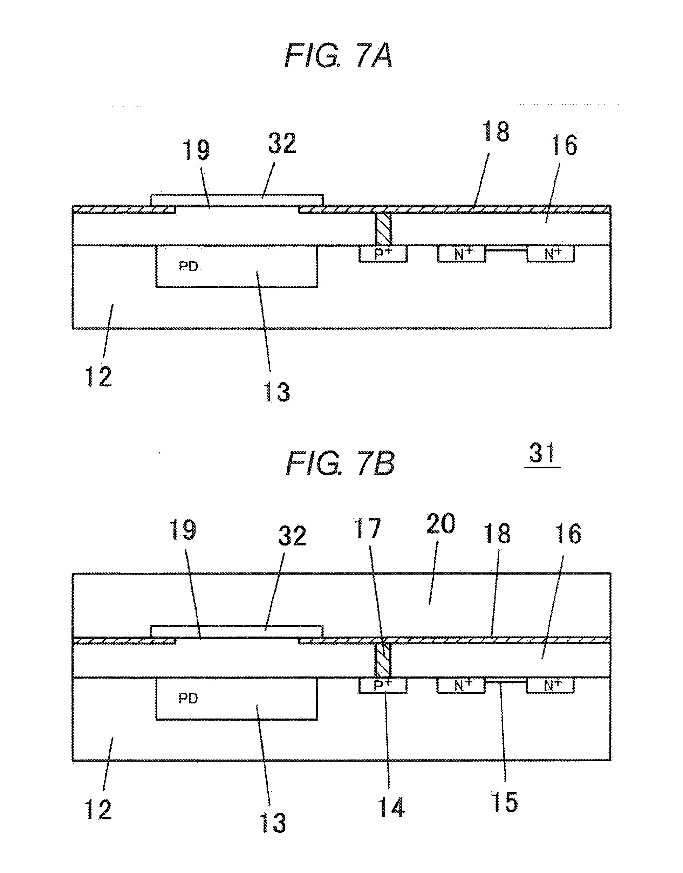

The manufacturing steps of the light sensor 31 will now be described with Figs. 6A, 6B, and Figs. 7A, 7B. As shown in Fig. 6A, the step of forming the insulating layer 16, the conductive post 17, and the light shielding metal 18 on the upper surface of the silicon substrate 12 fabricated with the photodiode 13, the contact region 14, the IC circuit 15, and the like, until opening the light receiving window 19 in the light shielding metal 18 is as described in the conventional example, and thus the description up to this step will not be given.

After opening the light receiving window 19 in correspondence to the photodiode 13 as in Fig. 6A, the conductive optical filter 32 is formed over the entire upper surface of the light shielding metal 18, as shown in Fig. 6B. Thereafter, as shown in Fig. 7A, leaving the conductive optical filter 32 at the position facing the upper side of the photodiode 13, the conductive optical filter 32 of other regions is removed through etching and the like. Furthermore, as shown in Fig. 7B, the insulating film 20 made of SiO₂ is formed on the upper surface of the light shielding metal 18 and the conductive optical filter 32 to thereby fabricate the target light sensor 31.

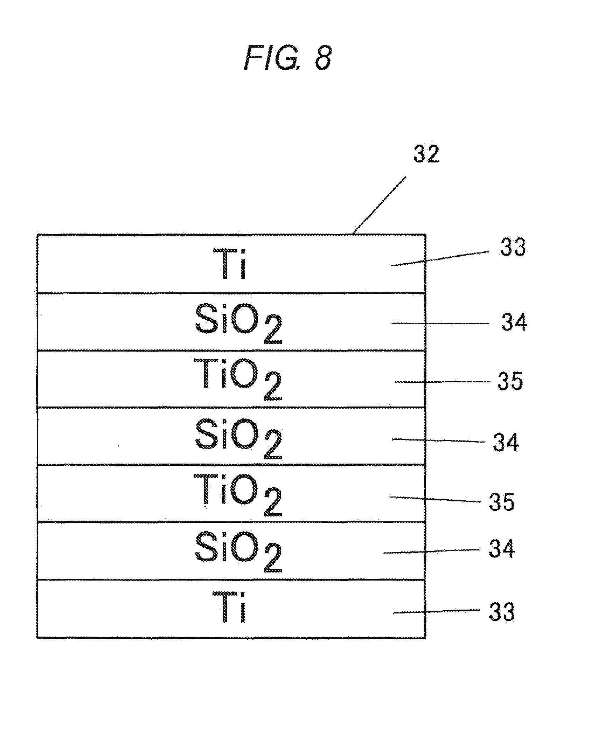

The conductive optical filter 32 has a structure in which a transparent conductive film (metal thin film) is formed on both surfaces or one surface of the optical filter. One example of a configuration of such a conductive optical filter 32 is shown in Fig. 8. In such a conductive optical filter 32, a multilayer film filter is configured by stacking an SiO₂ film 34 (insulating body) and a TiO₂ film 35 (insulating body) by two or more layers, and a Ti film 33 (metal) is formed on both surfaces as a transparent conductive film. Since the outer surface of the conductive optical filter 32 is configured by the Ti film 33, the Ti film 33 and the light shielding metal 18 contact and the conductive optical filter 32 is grounded when the conductive optical filter 32 is formed on the light shielding metal 18.

The multilayer film filter is configured by stacking a plurality of materials having different index of refraction. In addition to SiO₂ and TiO₂ described above, metal oxide such as MgO, CrO₂, Al₂O₃, CeO₂, HfO₂, Nb₂O₅, SnO₂, Ta₂O₅, Y₂O₃, and ZrO₂, and nitride such as SiN and TiN can be used for the multilayer film material. Furthermore, metals such as Al, Ag, Cu, Mo, and Cr can be used other than Ti for the material of the upper and lower transparent conductive films.

Such multilayer film materials and transparent conductive materials are formed during the production process of the light sensor 31, and thus need to have resistance with respect to temperature etc. used in the production process. For instance, since heat of about 400° is generally added in the process temperature in the formation of the light shielding metal, the organic thin film is inappropriate. The film forming method may be vapor deposition, sputtering, MBE, ion plating and the like. In the step of patterning so as to leave the film only at the upper side of the light receiving window 19, a pattern is formed with a resist on the necessary region, and then the portion exposed from the resist is removed with dry etching and ion milling to fabricate the conductive optical filter 32 of a predetermined shape.

The number of usage materials of the multilayer film filter is determined by the desired optical characteristics. In the example shown in Fig. 8, the multilayer filter is configured by repeating two types of layers of SiO₂/TiO₂, but may be two or more types of layers as long as the structure is a multilayer structure including thin film layers of different index of refraction, and three types of layers may be repeated as in a layer/b layer/ c layer. The number of layers of the multilayer filter can be appropriately determined according to the characteristics such as wide and narrow of the transmissive wavelength band of the conductive optical filter 32.

### (Second Embodiment)

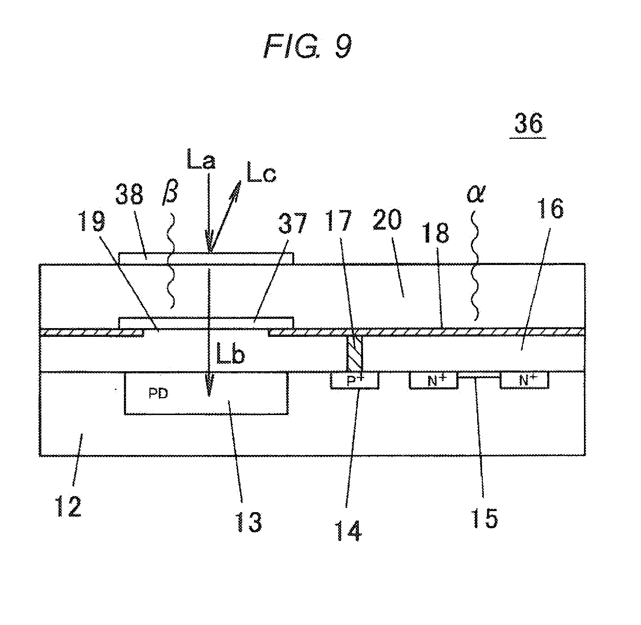

Fig. 9 is a cross-sectional view schematically showing a light sensor 36 according to a second embodiment of the present invention. In this embodiment, the light receiving window 19 of the light shielding metal 18 is covered with a transparent conductive film 37, and an optical filter 38 is formed on the insulating layer 20 so as to face the light receiving window 19. The transparent conductive film 37 is preferably a transparent conductive film having a wide light transmissive wavelength band, and may be an ITO (Indium Tin Oxide), ZnO transparent conductive film, In₂O₃-ZnO transparent conductive film, Ga added ZnO film and the like. The optical filter 38 may be a multilayer film including two or more thin films; and is, for example, a band-pass filter having a transmissive wavelength band in the infrared region etc.

Since the function of the electromagnetic shield and the function of the optical filter in the light detection region are separated to the transparent conductive film 37 and the optical filter 38 in the light sensor 36 of the embodiment, the restriction of the transparent conductive film 37 and the optical filter 38 becomes small and the degree of freedom in selecting the materials thereof becomes high.

Furthermore, the optical filter 38 can be attached to the light sensor 36 afterwards since the optical filter 38 is arranged on the outer surface of the insulating layer 20. Thus, in the assembly manufacturing company and the like, the optical filter 38 suited for application can be attached on the upper surface of the light sensor 36 for use at the stage before incorporating the light sensor 36 to the device, whereby the versatility of the light sensor 36 improves.

Although not illustrated, an embodiment in which the optical filter 38 is removed from the light sensor 36 of the second embodiment may be adopted. In other words, the optical filter 38 may not be provided, and the light receiving window 19 may be covered with merely the transparent conductive film 37.

### (Third Embodiment)

Although not illustrated, the optical characteristics of the conductive optical filter 32 of the first embodiment and the optical filter 38 of the second embodiment may be transmitting light of three wavelength bands. For instance, assuming red light (λ = around 650 nm), green light (λ = around 550 nm), and blue light (λ = around 450 nm), application can be made to a color imaging element such as a CCD.

## Claims

1. A light sensor (11, 31, 36), **characterized in that** an element forming region excluding a light detection region (13) is covered with a conductive film (18) having a light shielding property, the light detection region (13) being covered with a conductive film (32, 37) having a light transmissive property.

2. The light sensor (11, 31, 36) according to claim 1, **characterized in that** the conductive film (32, 37) having the light transmissive property has optical filter characteristics.

3. The light sensor (11, 31, 36) according to claim 1, **characterized in that** the conductive film (32, 37) having the light transmissive property electrically contacts the conductive film (18) having the light shielding property.
